# EUROPEAN PATENT APPLICATION

(11) **EP 4 810 964 A1**
(43) Date of publication of application: **23.09.2026**
(21) Application number: 25823310.5
(22) Date of filing: 13.01.2025
(51) Int. Cl.: G01R 31/08, G01R 31/54, G01R 1/04

(54) **CABLE CONTINUITY TEST APPARATUS AND METHOD**

(30) Priority: 08.11.2024 CN 202411592456
(71) Applicant: Jiangsu Bozhiwang Automation Equipment Co., Ltd., Changzhou, Jiangsu 213125 (CN)
(72) Inventor: SI, Xiangliang, Changzhou, Jiangsu 213125 (CN); SI, Weiliang, Changzhou, Jiangsu 213125 (CN); PEI, Yatao, Changzhou, Jiangsu 213125 (CN)
(74) Representative: Chung, Hoi Kan
(86) International application number: PCT/CN2025/072059
(87) International publication number: WO 2026/097705

(57) **Abstract**

The present invention relates to the technical field of cable processing, and in particular, relates to a cable continuity testing device, including: a cable gripping assembly, which includes gripping jaws for gripping a sheath of a cable; a testing assembly arranged opposite to a gripping center of the cable gripping assembly, wherein the testing assembly includes two first testing grippers, two second testing grippers and two third testing grippers, the first testing grippers are cylinders for gripping a shielding layer, the second testing grippers and the third testing grippers are sheet-shaped and each have a semicircular groove at an end facing the cable, the two sets of semicircular grooves are configured to grip an insulating layer and a central conductor of the cable, respectively; wherein the two semicircular grooves of the second testing grippers are combined to form a circle that matches an outer diameter of the insulating layer, and the two second testing grippers are conductive and can be electrically conducted therebetween when the insulating layer is gripped properly; and the first testing grippers, the second testing grippers and the third testing grippers are further configured for electrical continuity testing between any two thereof.

## Description

### TECHNICAL FIELD

The present invention relates to the technical field of cable processing, and in particular, relates to a cable continuity testing device and method.

### BACKGROUND

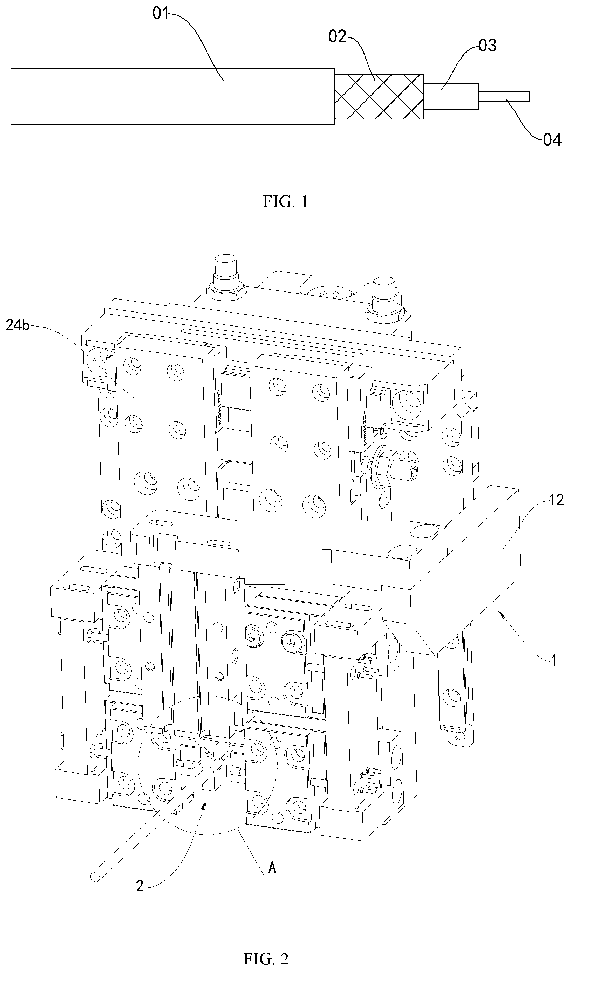

As shown in FIG. 1, a cable typically consists of a sheath 01, a shielding layer 02, an insulating layer 03 and a central conductor 04. If a quality problem occurs to at least one layer of the cable that has been applied to fields such as health care and transportation, a fault when occurred will cause a serious failure that is difficult to eliminate. Hence, the quality of the cable should be tested.

In the related art, the sheathing condition of a cable is generally tested by a visual inspection mechanism, in which the cable is gripped and visually identified to determine whether the electrical conductivity and other properties of the cable are in a good condition, by means of a visual inspection method.

However, the above method has problems with insufficient accuracy and low efficiency in cable quality testing. It has a high requirement for positioning accuracy in cable gripping during cable testing, yet it is difficult to determine whether the cable is positioned at a region to be tested, leading to inaccurate testing results. Moreover, visual inspection is prone to problems such as determination errors.

### SUMMARY

In view of at least one of the above technical problems, the present invention provides a cable continuity testing device and method, in which proper positioning testing and electrical continuity testing are performed by means of first, second and third testing grippers so as to ensure the testing of cable continuity in the case that the cable is properly positioned.

According to a first aspect of the present invention, a cable continuity testing device is provided. The cable continuity testing device includes:
a cable gripping assembly, which includes gripping jaws for gripping a sheath of a cable;
a testing assembly arranged opposite to a gripping center of the cable gripping assembly, wherein the testing assembly includes two first testing grippers, two second testing grippers and two third testing grippers, the first testing grippers are cylinders for gripping a shield layer, the second testing grippers and the third testing grippers are sheet-shaped and each have a semicircular groove at an end facing the cable, and the two sets of semicircular grooves are configured to grip an insulating layer and a central conductor of the cable, respectively;
wherein the two semicircular grooves of the second testing grippers are combined to form a circle that matches an outer diameter of the insulating layer, and the two second testing grippers are conductive and can be electrically conducted therebetween when the insulating layer is gripped properly; and the first testing grippers, the second testing grippers and the third testing grippers are further configured for electrical continuity testing between any two thereof.

In some embodiments of the present invention, gripping surfaces of the gripping jaws have a corner structure of 90 degrees, and the gripping jaws rotate on a plane perpendicular to the cable from an initial position towards the cable and stop a stroke until gripping the cable.

In some embodiments of the present invention, the two gripping jaws each have a plurality of engaged teeth profiles, the two gripping jaws are provided with cable gripping holes allowing the cable to pass through, and the cable gripping holes are shaped corresponding to a shape of the cable.

In some embodiments of the present invention, the cable continuity testing device further includes a first backplate, wherein the cable gripping assembly further includes a gripping arm, the gripping jaws are fixedly connected to the gripping arm, and the gripping arm is movably and fixedly connected to the first backplate.

In some embodiments of the present invention, the testing assembly includes a driver and two sliding plates connected to the driver; the first testing grippers, the second testing grippers and the third testing grippers are all fixed to the sliding plates; the driver is configured to drive the two sliding plates to be fixedly connected to the driver; and the driver drives the first testing grippers, the second testing grippers and the third testing grippers to move in a horizontal direction towards a direction close to or away from a cable harness.

In some embodiments of the present invention, the cable continuity testing device includes a second backplate, wherein the second backplate and the driver are connected by means of a tester slideway; the second backplate and the first backplate can be connected by sliding towards each other in a vertical direction; an electric actuator is arranged on a back of the first backplate and includes a movable rod that is connected to the second backplate; the movable rod is fixedly connected to the driver; and the electric actuator actuates the movable rod to move, thereby actuating the driver to drive the second backplate to move in the vertical direction.

In some embodiments of the present invention, at least one set of the first testing grippers, the second testing grippers and the third testing grippers is arranged on the second backplate.

In some embodiments of the present invention, the driver is an air-cylinder clamping jaw, both ends of which are fixedly connected to the two sliding plates, respectively.

In some embodiments of the present invention, the third testing grippers have teeth profiles that are engaged with each other.

According to a second aspect of the present invention, a cable continuity testing method is further provided, in which the cable continuity testing device as described in the first aspect is applied. The cable continuity testing method includes the steps of:
moving a cable to the gripping center of the testing assembly, and gripping a sheath of the cable to be tested by means of the gripping assembly;
closing the testing assembly to cause the first testing grippers to grip a shielding layer of the cable, the second testing grippers to grip an insulating layer, and the third testing grippers to grip a central conductor;
energizing the second testing grippers to determine a conduction condition between the two second testing grippers, if not conducted, giving an alarm indicating improper gripping, and if conducted, proceeding with the testing; and
performing electrical continuity testing between any two of the first testing grippers, the second testing grippers and the third testing grippers, and if a short circuit occurs between any two thereof, giving an alarm indicating shielding mesh overlap.

The advantageous effects of the present invention are as follows: according to the present invention, the semicircular grooves in the second testing grippers are combined to form the circle that matches the outer diameter of the insulating layer, and the electrical conductivity between the second testing grippers is tested, thereby determining whether the insulating layer is gripped properly; and compared to the prior art, the present invention ensures that the insulating layer is properly positioned, and guarantees that gripping occurs at the corresponding layer of the cable when the cable sheathing is inspected.

### BRIEF DESCRIPTION OF THE DRAWINGS

To describe the technical solutions in the embodiments of the present invention or in the prior art more clearly, the following briefly introduces the accompanying drawings required for describing the embodiments or the prior art. Obviously, the accompanying drawings in the following description show only some embodiments described in the present invention, and those of ordinary skill in the art may still derive other drawings from these accompanying drawings without creative effort.
FIG. 1 shows a schematic structural diagram of a cable to be tested in the background art of the present invention;
FIG. 2 shows a schematic structural diagram of a cable continuity testing device according to an embodiment of the present invention;
FIG. 3 shows a partially enlarged view at A shown in FIG. 2 according to an embodiment of the present invention;
FIG. 4 shows a schematic structural diagram of a cable gripping assembly according to an embodiment of the present invention;
FIG. 5 shows a schematic structural diagram of a gripping jaw according to an embodiment of the present invention;
FIG. 6 shows a schematic structural diagram of a cable continuity testing device according to an embodiment of the present invention from another angle of view;
FIG. 7 shows a schematic structural diagram of a cable continuity testing device according to an embodiment of the present invention from a back angle of view;
FIG. 8 shows a partially enlarged view at B shown in FIG. 5 according to an embodiment of the present invention;
FIG. 9 shows a schematic structural diagram of a testing assembly according to an embodiment of the present invention from a back angle of view;
FIG. 10 shows a flowchart of the steps of a cable continuity testing method according to an embodiment of the present invention from a back angle of view; and
FIG. 11 shows a diagram illustrating a structural state where a shielding wire in a shielding layer is overlapped with an insulating layer and a central conductor.

Description of reference signs: 1, cable gripping assembly; 11, gripping jaw; 11a, cable gripping hole; 12, gripping arm; 2, testing assembly; 21, first testing gripper; 22, second testing gripper; 23, third testing gripper; 24, driver; 24a, air-cylinder clamping jaw; 24b, sliding plate; 3, first backplate; 31, electric actuator; 4, second backplate; 01, sheath; 02, shielding layer; 03, insulating layer; 04, central conductor.

### DETAILED DESCRIPTION OF THE INVENTION

The technical solutions in the embodiments of the present invention will be described clearly and completely below in conjunction with the accompanying drawings in the embodiments of the present invention. Obviously, the embodiments described are merely some instead of all of the embodiments of the present invention.

It should be noted that when an element is referred to as being "fixed to" another element, said element can be disposed on said another element directly or possibly with an element centered therebetween. When an element is considered as being "connected to" another element, said element can be connected to said another element directly or possibly with an element centered therebetween at the same time. The terms "perpendicular", "horizontal", "left", "right" and other similar expressions as used herein are for an illustrative purpose, instead of representing a unique implementation.

Unless otherwise defined, all the technical and scientific terms as used herein have the same meanings as those commonly understood by those skilled in the art of the present invention. The terms as used herein in the Description of the present invention are merely for the purpose of describing specific embodiments, and are not intended to limit the present invention. The term "and/or" as used herein includes any and all combinations of one or more associated listed items.

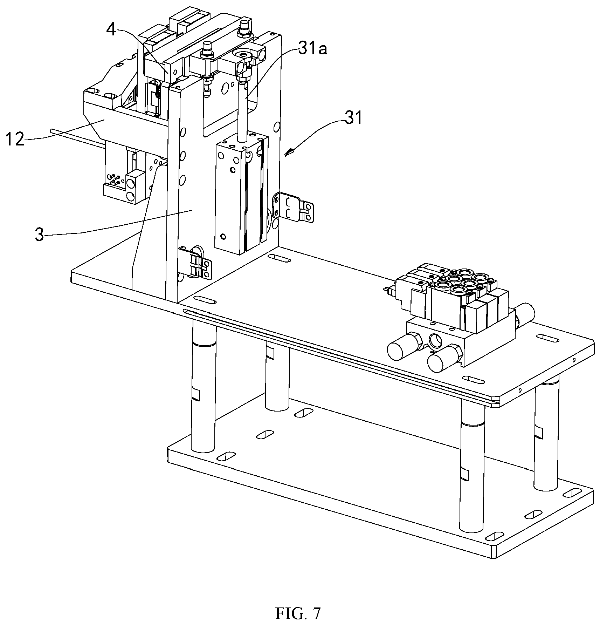

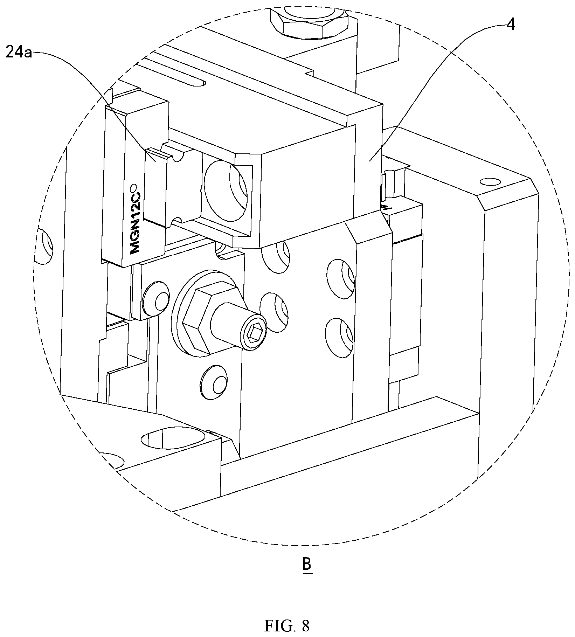

The cable continuity testing device as shown in FIGS. 2 to 9 and FIG. 11 includes: a cable gripping assembly 1 and a testing assembly 2.

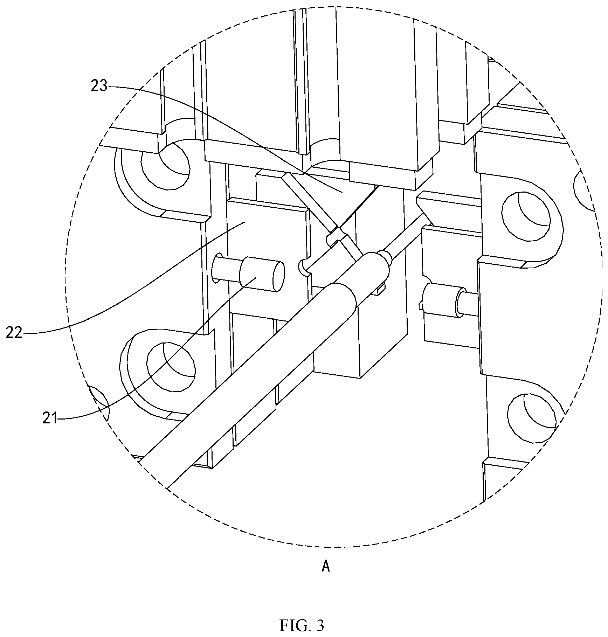

In some embodiments of the present invention, as shown in FIGS. 3 to 4, the cable gripping assembly 1 includes gripping jaws 11 for gripping a sheath 01 of a cable. The provision of the gripping jaws 11 allows for gripping the cable and fixing the sheath 01 of the cable in an automated manner to provide conditions for properly positioning the cable, such that the cable can be tested while being fixed. Here, it should be noted that the gripping jaws 11 achieve a gripping action mechanically or electrically, and the specific structural form of the gripping jaws 11 can be set by those skilled in the art as required.

As shown in FIGS. 2 to 3, the testing assembly 2 is arranged opposite to a gripping center of the cable gripping assembly 1, and includes two first testing grippers 21, two second testing grippers 22 and two third testing grippers 23. The first testing grippers 21 are cylinders for gripping a shielding layer 02; the second testing grippers 22 and the third testing grippers 23 are sheet-shaped and each have a semicircular groove at an end facing the cable; and the two sets of semicircular grooves are configured to grip an insulating layer 03 and a central conductor 04 of the cable, respectively. During testing, the two second testing grippers 22 or the two third testing grippers 23 can be conducted (indicating proper gripping of the cable) only when the grooves completely fit the cable and the two second testing grippers 22 come into contact, or the two third testing grippers 23 come into full contact. The first testing grippers 21, the second testing grippers 22 and the third testing grippers 23 are sheet-shaped, such that the first testing grippers 21, the second testing grippers 22 and the third testing grippers 23 can be conveniently replaced in case of abrasion or other faults, leading to reduced maintenance and replacement cost. Moreover, the convenient replacement of the first testing grippers 21, the second testing grippers 22 and the third testing grippers 23 allows for adjustment of the aperture of the semicircular grooves, enabling the cable continuity testing device to adapt to a wider range of cables.

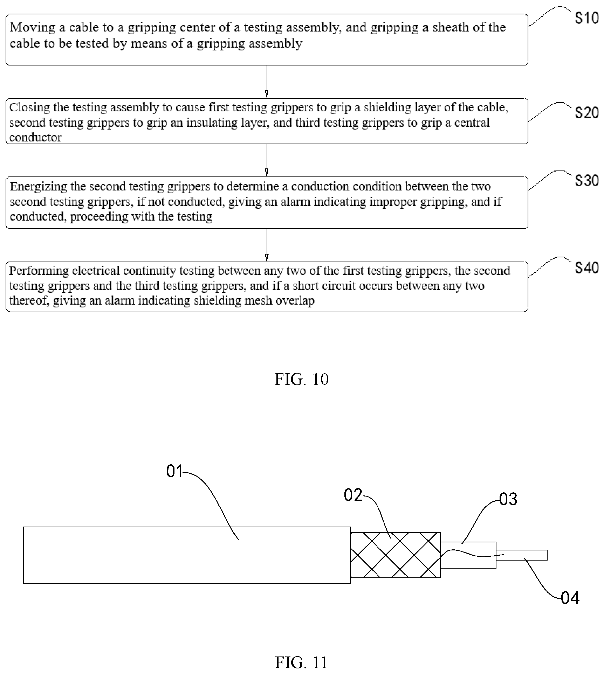

Still referring to FIGS. 2 to 3 and FIG. 11, the two semicircular grooves of the second testing grippers 22 are combined to form a circle that matches the outer diameter of the insulating layer 03, and the two second testing grippers 22 are conductive and may be electrically conducted therebetween when the insulating layer 03 is gripped properly. The first testing grippers 21, the second testing grippers 22 and the third testing grippers 23 are further configured for electrical continuity testing between any two thereof. A specific testing process is as follows: the cable gripping assembly 1 grips the middle section of the sheath 01 of the cable to keep the cable positioned horizontally during testing; the second testing grippers 22 grip the insulating layer 03 of the cable; if improper gripping prevents the insulating layer 03 from being positioned in and fitting the grooves, the two second testing grippers 22 do not contact, in which case the second testing grippers 22 cannot be conducted after energization, indicating an incorrect gripping position, and an alarm is given; and then, short-circuit testing is performed to determine whether the shielding layer 02 is overlapped with the insulating layer 03 or the central conductor 04. FIG. 11 shows the situation where a shielding wire in the shielding layer 02 is overlapped with the insulating layer 03 and the central conductor 04, in which case electrical continuity testing can be performed between any two of the first testing grippers 21, the second testing grippers 22 and the third testing grippers 23. For example, the first testing grippers 21 and the second testing grippers 22 can be conducted therebetween, or the first testing grippers 21 and the third testing grippers 23 can be conducted therebetween, or the second testing grippers 22 and the third testing grippers 23 can be conducted therebetween, indicating that the wire in the shielding layer 02 has been overlapped with the insulating layer 03 or the central conductor 04. In this case, the cable quality is determined to be unacceptable, and an alarm indicating shielding mesh overlap is then given. In order to avoid this case, it is necessary to test the shielding layer 02. When the wire in the shielding layer 02 is overlapped with the insulating layer 03, the integrity of the insulating layer 03 may be damaged to lead to a degraded insulating property, making the cable prone to electrical leakage or breakthrough to increase the risk of electric accidents. When the wire in the shielding layer 02 is overlapped with the insulating layer 03 or the central conductor 04, the consistency of the shielding layer 02 may be damaged. If the wire in the shielding layer 02 is overlapped with the central conductor 04, a short-circuit loop may be formed, which, under excessive current conditions, may cause the cable to overheat, burn down or even pose other potential safety hazards such as fire. The provision of the cable gripping assembly 1, the first testing grippers 21, the second testing grippers 22 and the third testing grippers 23 can ensure that gripping occurs at a defined position during cable testing, such that the overlapped shielding wire in the shielding layer 02 can be accurately detected, thereby improving the testing accuracy and the efficiency in cable quality testing at the same time.

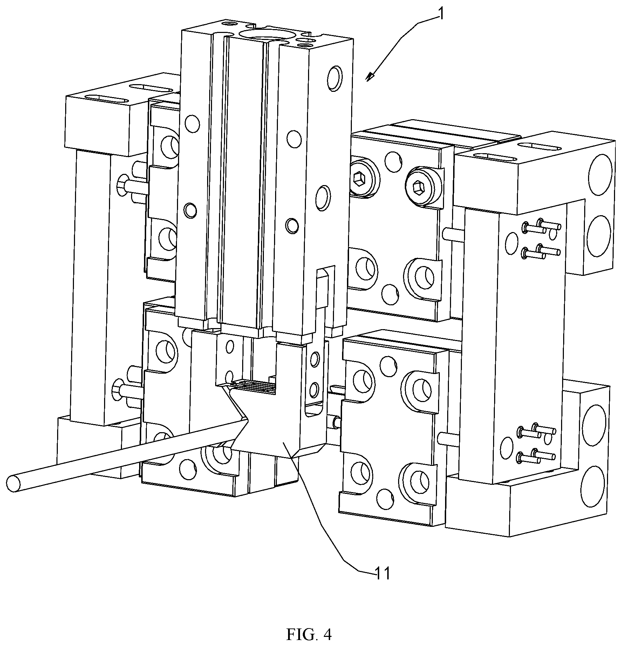

In some embodiments of the present invention, as shown in FIGS. 4 to 5, the gripping surfaces of the gripping jaws 11 have a corner structure of 90 degrees, and the gripping jaws 11 rotate on a plane perpendicular to the cable from an initial position towards the cable and stop a stroke until gripping the cable. For example, when the cable is moved into the cable continuity testing device, the gripping jaws 11 rotate from the initial position towards the cable in an arc-shaped trajectory that is located on a plane perpendicular to the cable, and the gripping jaws 11 grip and immobilize the cable, providing stable conditions for cable testing. Here, it should be noted that the gripping jaws 11 have a certain holding capacity to prevent the gripped cable from deformation and any movement.

In order to further guarantee the cable quality and improve the accuracy in cable quality testing, in some embodiments of the present invention, still referring to FIGS. 4 to 5, the gripping jaws 11 each have a plurality of engaged teeth profiles, and the two gripping jaws 11 are provided with cable gripping holes 11a allowing the cable to pass through, and the cable gripping holes 11a are shaped corresponding to the shape of the cable. The same circular shape as the cable enables the gripping jaws 11 to tightly fit the shape of the cable and to prevent the cable from sliding or falling during testing, thereby improving gripping accuracy and stability and avoiding causing excessive extrusion or damage to the cable. Moreover, the gripping jaws 11 each have a separate rotatable structure and are connected by means of bolts and screws, such that the clamping jaws are convenient to replace; and the gripping jaws 11 that are convenient to replace may have the cable gripping holes 11a of different diameters, enabling the device to adapt to cables of more sizes.

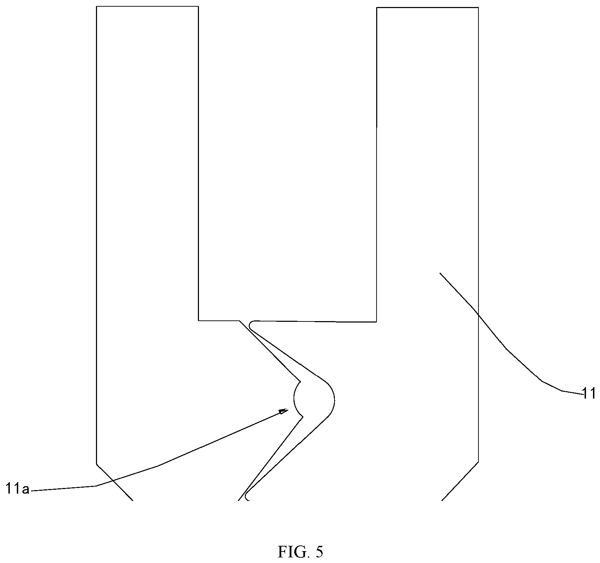

In some embodiments of the present invention, as shown in FIGS. 5 to 7, the cable continuity testing device further includes a first backplate 3, and the cable gripping assembly 1 further includes a gripping arm 12, the gripping jaws 11 are fixedly connected to the gripping arm 12, and the gripping arm 12 is fixedly connected to the backplate 3. Here, it should be noted that the gripping arm 12 and the gripping jaws 11, or the gripping arm 12 and the backplate 3, may be fixed to each other by means of bolts, welding, splicing and the like, the gripping arm 12 moves to drive the entire gripping jaws 11 to move, and the gripping jaws 11 then separately grip the cable. In such an arrangement, the position of the gripping jaw 11 can be adjusted more accurately to position the cable more accurately, thereby improving the accuracy in cable quality testing.

In some embodiments of the present invention, as shown in FIGS. 5 to 8, the testing assembly includes a driver 24 and two sliding plates 24b connected to the driver 24; the first testing grippers 21, the second testing grippers 22 and the third testing grippers 23 are all fixed to the sliding plates 24b; and the driver 24 is configured to drive the two sliding plates 24b to move in a horizontal direction towards a direction close to or away from a cable harness. The provision of the driver 24 can ensure the stable connection among the first testing grippers 21, the second testing grippers 22, the third testing grippers 23 and the driver 24. Moreover, the first testing grippers 21, the second testing grippers 22 and the third testing grippers 23 are fixed to the two sliding plates 24b and thus can move towards the cable in the horizontal direction at the same height. This can ensure that the semicircular grooves in the opposing second testing grippers 22 and the opposing third testing grippers 23 can form circular holes corresponding to the shapes of the insulating layer 03 and the central conductor 04 of the cable, respectively, such that the accuracy in cable quality testing is ensured.

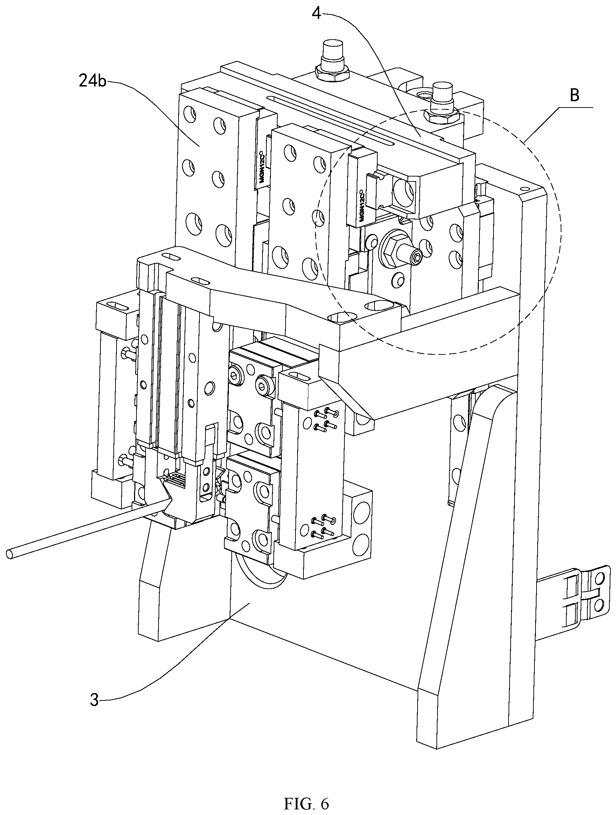

In some embodiments of the present invention, as shown in FIGS. 6 to 9, the cable continuity testing device includes a second backplate 4; the second backplate 4 and the first backplate 3 can be connected by sliding towards each other in a vertical direction; and an electrical actuator 31 is arranged on the back of the first backplate 3, and is connected to the second backplate 4 to drive the second backplate 4 to move in the vertical direction. The connection by sliding provides a stable movement path for the driver and ensures the smoothness and accuracy of the driver during moving, and the electrical actuator 31a causes the second backplate 4 to move linearly in the vertical direction by means of a motor-driven internal mechanical structure such as a lead screw. In such an arrangement where the second backplate 4 and the first backplate 3 can be connected by sliding towards each other in the vertical direction and the electrical actuator 31 drives the second backplate 4 to move in the vertical direction, the first testing grippers 21, the second testing grippers 22 and the third testing grippers 23 can be accurately positioned in a three-dimensional space.

In some embodiments of the present invention, as shown in FIGS. 6 to 9, at least one set of the first testing grippers 21, the second testing grippers 22 and the third testing grippers 23 is arranged on the second backplate 4. When a plurality of sets of the first testing grippers 21, the second testing grippers 22 and the third testing grippers 23 is arranged on the second backplate 4 in the vertical direction, the device can be enabled to test a plurality of cables of different heights at the same time, thereby improving the testing efficiency; the arrangement of two or more sets of the first testing grippers 21, the second testing grippers 22 and the third testing grippers 23 in the vertical direction allows for greater flexibility in using the device, and when a problem occurs to one set of the first testing grippers 21, the second testing grippers 22 and the third testing grippers 23, a further set of the first testing grippers 21, the second testing grippers 22 and the third testing grippers 23 can be used for testing. Here, it should be noted that the first testing grippers 21, the second testing grippers 22 and the third testing grippers 23 can be fixed to the second backplate 4 by means of welding, splicing or bonding.

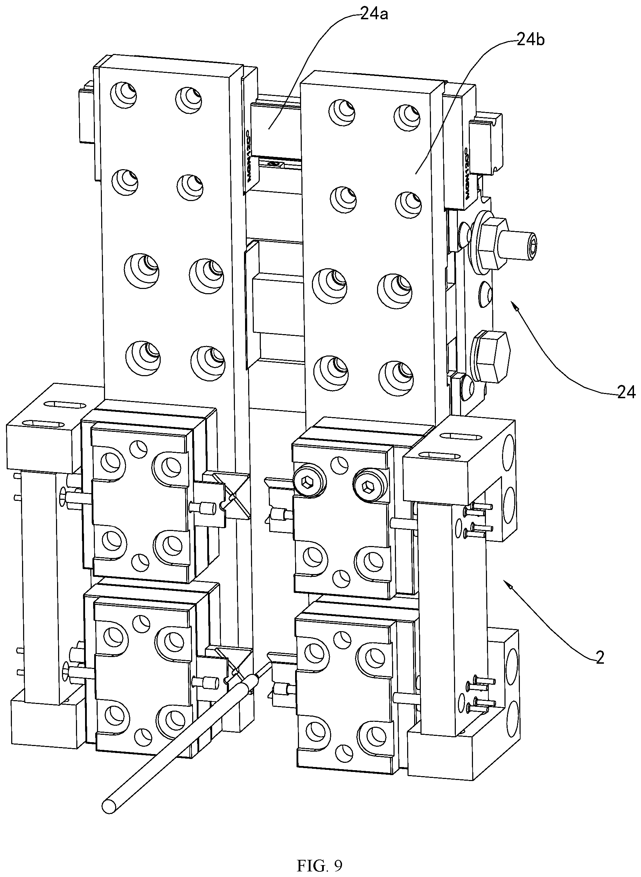

In some embodiments of the present invention, referring to FIG. 9, the driver 24 is an air-cylinder clamping jaw 24a, both ends of which are fixedly connected to the two sliding plates 24b, respectively. The provision of the air-cylinder clamping jaw 24a further ensures that the opposing first testing grippers 21, the opposing second testing grippers 22 and the opposing third testing grippers 23 can move towards the cable along the same straight line on a plane perpendicular to the cable, such that the opposing contact surfaces of the first testing grippers 21, the second testing grippers 22 and the third testing grippers 23 can contact accurately to further ensure the accuracy in cable quality testing.

In some embodiments of the present invention, the third testing grippers 23 have teeth profiles that are engaged with each other. With the engaged teeth profiles, when the two opposing third testing grippers 23 come into contact, the current is allowed to flow through only when the teeth profiles come into full contact. This ensures that the central conductor 04 remains positioned within the grooves, and the cable is gripped at a correct position.

Referring to FIG. 10, the present invention further provides a cable continuity testing method, which includes the steps of:
S10: moving a cable to the gripping center of the testing assembly, and gripping a sheath of the cable to be tested by means of the gripping assembly;
S20: closing the testing assembly to cause the first testing grippers to grip a shielding layer of the cable, the second testing grippers to grip an insulating layer, and the third testing grippers to grip a central conductor;
S30: testing conductivity between the two second testing grippers and between the two third testing grippers, respectively; and
S40: performing electrical continuity testing between any two of the first testing grippers, the second testing grippers and the third testing grippers, and if a short circuit occurs between any two thereof, giving an alarm indicating shielding mesh overlap.

The detailed steps of the cable continuity testing method have been provided in the description in connection to the above cable continuity testing device, which will not be repeated here.

Those skilled in the industry should understand that the present invention is not limited by the embodiments described above. The descriptions in the above embodiments and Description are merely for a purpose of describing the principle of the present invention. A variety of variations and improvements can also be made to the present invention without departing from the spirit and scope of the present invention. These variations and improvements shall fall within the scope claimed by the present invention. The scope claimed by the present invention is subjected to the appended claims and equivalents thereof.

## Claims

1. A cable continuity testing device, comprising:
a cable gripping assembly, which comprises gripping jaws for gripping a sheath of a cable;
a testing assembly arranged opposite to a gripping center of the cable gripping assembly, wherein the testing assembly comprises two first testing grippers, two second testing grippers and two third testing grippers, the first testing grippers are cylinders for gripping a shield layer, the second testing grippers and the third testing grippers are sheet-shaped and each have a semicircular groove at an end facing the cable, and the two sets of semicircular grooves are configured to grip an insulating layer and a central conductor of the cable, respectively;
wherein the two semicircular grooves of the second testing grippers are combined to form a circle that matches an outer diameter of the insulating layer, and the two second testing grippers are conductive and can be electrically conducted therebetween when the insulating layer is gripped properly; and the first testing grippers, the second testing grippers and the third testing grippers are further configured for electrical continuity testing between any two thereof.

2. The cable continuity testing device according to claim 1, wherein gripping surfaces of the gripping jaws have a corner structure of 90 degrees, and the gripping jaws rotate on a plane perpendicular to the cable from an initial position towards the cable and stop a stroke until gripping the cable.

3. The cable continuity testing device according to claim 2, wherein the two gripping jaws each have a plurality of engaged teeth profiles, the two gripping jaws are provided with cable gripping holes allowing the cable to pass through, and the cable gripping holes are shaped corresponding to a shape of the cable.

4. The cable continuity testing device according to claim 2, further comprising: a first backplate, wherein the cable gripping assembly further comprises a gripping arm, the gripping jaws are fixedly connected to the gripping arm, and the gripping arm is fixedly connected to the first backplate.

5. The cable continuity testing device according to claim 4, wherein the testing assembly comprises a driver and two sliding plates connected to the driver; the first testing grippers, the second testing grippers and the third testing grippers are all fixed to the sliding plates; and the driver is configured to drive the two sliding plates to move in a horizontal direction towards a direction close to or away from a cable harness.

6. The cable continuity testing device according to claim 5, comprising a second backplate, wherein the second backplate and the first backplate can be connected by sliding towards each other in a vertical direction, and an electric actuator is arranged on a back of the first backplate and is connected to the second backplate to drive the second backplate to move in the vertical direction.

7. The cable continuity testing device according to claim 6, wherein at least one set of the first testing grippers, the second testing grippers and the third testing grippers is arranged on the second backplate.

8. The cable continuity testing device according to claim 7, wherein the driver is an air-cylinder clamping jaw, both ends of which are fixedly connected to the two sliding plates, respectively.

9. The cable continuity testing device according to claim 1, wherein the third testing grippers have teeth profiles that are engaged with each other.

10. A cable continuity testing method, in which the cable continuity testing device according to any one of claims 1 to 9 is applied, wherein the cable continuity testing method comprises the steps of:
moving a cable to the gripping center of the testing assembly, and gripping a sheath of the cable to be tested by means of the gripping assembly;
closing the testing assembly to cause the first testing grippers to grip a shielding layer of the cable, the second testing grippers to grip an insulating layer, and the third testing grippers to grip a central conductor;
energizing the second testing grippers to determine a conduction condition between the two second testing grippers, if not conducted, giving an alarm indicating improper gripping, and if conducted, proceeding with the testing; and
performing electrical continuity testing between any two of the first testing grippers, the second testing grippers and the third testing grippers, and if a short circuit occurs between any two thereof, giving an alarm indicating shielding mesh overlap.
